# EUROPEAN PATENT SPECIFICATION

(11) **EP 4 451 382 B1**
(45) Date of publication and mention of the grant of the patent: **15.07.2026**
(21) Application number: 24167585.9
(22) Date of filing: 28.03.2024
(51) Int. Cl.: H01M 4/36, H01M 4/525, H01M 4/58, H01M 4/62, H01M 4/66, H01M 10/0525, C23C 14/16, H01M 4/02

(54) **SECONDARY BATTERY AND ELECTRONIC DEVICE**
SEKUNDÄRBATTERIE UND ELEKTRONISCHE VORRICHTUNG
BATTERIE SECONDAIRE ET DISPOSITIF ÉLECTRONIQUE

(30) Priority: 31.03.2023 CN 202310335017
(43) Date of publication of application: 23.10.2024
(73) Proprietor: Ningde Amperex Technology Ltd., Ningde City, Fujian 352100 (CN)
(72) Inventor: HU, Kewen, Ningde City, Fujian Province, People s Republic of China, 352100 (CN)
(74) Representative: Icosa

(56) References cited:
- CN-A- 115 149 000
- US-A1- 2020 144 600
- US-A1- 2021 151 772
- US-A1- 2022 223 836

## Description

### TECHNICAL FIELD

The present application relates to the field of electrochemical technology, in particular to a secondary battery, and an electronic device.

### BACKGROUND

Secondary batteries, such as lithium-ion batteries, are widely used in the field of consumer electronics with features of high specific energy, high operating voltages, low self-discharge rates, small sizes, light weights, etc. With the wide application of lithium-ion batteries, their safety performance is increasingly required.

In the related technology, in order to improve the performance such as the energy density, cycle performance, and safety performance of the secondary battery, positive electrode plates comprising one or more layers covering the current collector have been developed. US 2021/151772 describes a current collector comprising on active material layer coating the current collector providing improved power performance. The presence of two superimposed active material layers lying down the current collector and cold-pressed together also lead to improved performance in batteries (US 2020/144600). In parallel, such structures have proved to be efficient to improve mechanical properties. This is the case of CN 115149000 where the current collector comprises a polymer material film coated with an aluminum metal layer, or US 2022/223836 where the current collector is covered with a functional coating layer, itself comprising an active material, and covered by an electrode active material layer. However, the above-described technical solution causes some problems, such as an increase in the internal resistance growth rate, a decrease in the rate performance, and a decrease in the product yield of the secondary battery. Therefore, there is still a need to develop batteries, and in particular electrode plates allowing to improve the energy density, cycle performance, and safety performance of the secondary battery.

### SUMMARY

It is an objective of the present application to provide a secondary battery, and an electronic device to enable the secondary battery to have good safety performance and also an increased internal resistance growth rate.

As a note, in the disclosure of the application, the secondary battery is illustrated by taking a lithium-ion battery as an example to explain the present application, but the secondary battery of the application is not limited to the lithium-ion battery. The specific technical solution is as follows.

A first aspect of the present application provides a secondary battery. The secondary battery includes a positive electrode plate, the positive electrode plate includes a current collector, a first active substance layer, and a second active substance layer, the first active substance layer includes a first active substance, the second active substance layer includes a second active substance, the difference between the Dv50 of the second active substance and the Dv50 of the first active substance is a µm, where 2≤a≤10; and the current collector includes an aluminum foil, and an aluminized layer, the second active substance layer, the first active substance layer, the aluminized layer, and the aluminum foil are laminated, the aluminized layer is disposed on a first surface of the aluminum foil, and the aluminized layer is in direct contact with the first active substance layer. The present application enables the secondary battery having a good safety performance and also a reduced internal resistance growth rate by disposing, on the surface of the aluminum foil, the aluminized layer which can be better bonded with the first active substance layer with the characteristics of the aluminized layer, such as a strong gas barrier property, a certain surface roughness, and good compactness, and by adjusting the difference between the Dv50 of the second active substance and the Dv50 of the first active substance to be within the range of the present application under the described above structure. In the present application, Dv50 means a particle size value in which a volume cumulant reaches 50% from a small particle size side in the particle size distribution on volume basis.

In some implementations of the present application, the aluminized layer has the thickness of 0.1 µm to 1 µm. By adjusting the thickness of the aluminized layer to be within the scope of the present application and by using the characteristics of the aluminized layer, such as a strong gas barrier property, a certain surface roughness, and good compactness, the secondary battery has a good safety performance and also a reduced internal resistance growth rate.

In some implementations of the present application, the Dv50 of the first active substance is 0.05 µm to 8 µm, and the Dv50 of the second active substance is 5 µm to 18 µm, so that the secondary battery has a good safety performance and also a reduced internal resistance growth rate.

In some implementations of the present application, the difference between the Dv50 of the second active substance and the Dv50 of the first active substance is a µm, where 2≤a≤6, and the aluminized layer has the thickness of H µm, where 0.1≤H≤0.5, facilitating to reduce the internal resistance growth rate of the secondary battery.

In some implementations of the present application, the difference between the Dv50 of the second active substance and the Dv50 of the first active substance is a µm, where 6<a≤10, and the aluminized layer has the thickness of H µm, where 0.5<H≤1, facilitating to reduce the internal resistance growth rate of the secondary battery.

In some implementations of the present application, the first active substance includes at least one of lithium iron phosphate, lithium iron manganese phosphate, or lithium manganate, facilitating to improve the safety performance of the secondary battery; and the second active substance includes at least one of lithium cobaltate, lithium nickelate, lithium manganate, or a nickel-cobalt-manganese ternary, or lithium-rich manganese-based material, facilitating to reduce the occurrence of a side reaction between the positive electrode active substance and the electrolyte, and then improve the cycle performance and energy density of the secondary battery.

In some implementations of the present application, the first active material layer includes lithium iron phosphate. By adjusting the first active substance layer to be lithium iron phosphate, it is facilitated to improving the safety performance of the secondary battery.

In some implementations of the present application, the first active substance layer further includes a conductive agent, and a binder, and based on the mass of the first active substance layer, the lithium iron phosphate has the mass percentage content of 70% to 85%, the conductive agent has the mass percentage content of 5% to 20%, and the binder has the mass percentage content of 0.5% to 5%. By adjusting the content of the conductive agent and binder in the first active substance layer to be within the above range, it is facilitated to further improve the safety performance of the secondary battery.

In some implementations of the present application, the first active substance layer has the thickness of b µm, where 0.5≤b≤ 5, and the aluminized layer has the thickness of H µm, where 0.1≤H≤0.5. By synergistically adjusting the thicknesses of the first active substance layer and the aluminized layer to be within the above range, if the secondary battery is punctured, the first active substance layer can effectively encapsulate the aluminum fragments formed by the fracture of the aluminized layer and current collector, improving the safety performance of the secondary battery by reducing the short circuit risk caused by the aluminum fragments, and improving the cycling performance of the secondary battery by reducing the internal resistance growth rate of the secondary battery.

In some implementations of the present application, the first active substance layer has the thickness of b µm, where 5<b≤10, and the aluminized layer has the thickness of H µm, where 0.5<H≤1. If the secondary battery is punctured, the first active substance layer can effectively encapsulate the aluminum fragments formed by the fracture of the aluminized layer and current collector, improving the safety performance of the secondary battery by reducing the short circuit risk caused by the aluminum fragments, and improving the cycling performance and energy density of the secondary battery by reducing the internal resistance growth rate of the secondary battery.

In some implementations of the present application, the current collector further includes a polymer matrix layer which is laminated with the aluminum foil, the polymer matrix layer is disposed on a second surface of the aluminum foil, and the second surface is opposite to the first surface. The above structure facilitates to improve the problem of a large internal resistance growth rate of the positive electrode plate of the secondary battery by reducing the contact impedance at the junction of the first active substance layer and current collector, thereby reducing the internal resistance growth rate of the secondary battery while enabling the secondary battery having a good safety performance.

In some implementations of the present application, the material of the polymer matrix layer is at least one of polyimide (PI), polyethylene terephthalate (PET), polyethylene (PE), polypropylene (PP), polyvinylidene chloride (PVDC), polyvinyl chloride (PVC), polytetrafluoroethylene (PTFE), or polyamide (PA). It is facilitated to improve the cycling performance of the secondary battery by selecting the above material for the polymer matrix layer and forming the aluminized layer on the current collector including the polymer matrix layer.

A second aspect of the present application provides an electronic device comprising the secondary battery described in any one of the preceding implementations.

The present application provides a secondary battery, and an electronic device. The positive electrode plate includes a current collector, a first active substance layer, and a second active substance layer, the first active substance layer includes a first active substance, the second active substance layer includes a second active substance, the difference between the Dv50 of the second active substance and the Dv50 of the first active substance is a µm, where 2≤a≤10; and the current collector includes an aluminum foil, and an aluminized layer, the second active substance layer, the first active substance layer, the aluminized layer, and the aluminum foil are laminated, the aluminized layer is disposed on a first surface of the aluminum foil, and the aluminized layer is in direct contact with the first active substance layer. The aluminized layer is disposed on the surface of the aluminum foil and is better bonded with the first active substance layer by using the characteristics of the aluminized layer, such as a strong gas barrier property, a certain surface roughness, and good compactness. By the structure described above and adjusting the difference between the Dv50 of the second active substance and the Dv50 of the first active substance to be within the range of the present application, the secondary battery has a good safety performance and also a reduced internal resistance growth rate.

Indeed, any one of the products or methods implementing the present application does not necessarily achieve all the described above advantages.

### BRIEF DESCRIPTION OF DRAWINGS

In order to more clearly illustrate the technical solutions in the embodiments of the present application or prior art, the figures to describe the embodiments or the prior art would be briefly introduced below. Obviously, the figures in the following description are only some embodiments of the present application. Other embodiments may be obtained by a person of ordinary skill in the art according to the figures.
FIG. 1 shows a schematic diagram of the structure of the positive electrode plate in some implementations of the present application;
FIG. 2 shows a schematic diagram of a first structure of a current collector in some implementations of the present application;
FIG. 3 shows a schematic diagram of a second structure of a current collector in some implementations of the present application;
FIG. 4 shows a schematic diagram of a third structure of a current collector in some implementations of the present application;
FIG. 5 shows a schematic diagram of a structure of a positive electrode plate in comparative embodiment 2; and
FIG. 6 shows a schematic diagram of nail penetration points of a secondary battery during a nail penetration test.

Reference numerals: 10-positive electrode plate, 11-current collector, 12-first active substance layer, 13-second active substance layer, 111-aluminized layer, 112-aluminum foil, 113-polymer matrix layer.

### DETAILED DESCRIPTION

The technical solutions in the embodiments of the present application are described in detail below in conjunction with the figures in the embodiments. Obviously, described embodiments are a part of the embodiments of the present application. Based on the embodiments of the present application, other embodiments obtained by a person of ordinary skill in the art are within the scope of protection of the application.

As a note, in the detailed description, the present application is explained by a lithium-ion battery as an example of a secondary battery, but the secondary battery of the present application is not limited to the lithium-ion battery. The specific technical program is as follows.

The inventor finds that a polymer-containing coating is applied to a surface of a current collector of a lithium-ion battery to reduce a short-circuit risk after puncture in the related technology. However, due to the resistance of the polymer-containing coating larger than that of an active substance layer, an internal resistance growth rate of a positive electrode plate is increase, and the internal resistance growth rate of the secondary battery is further increased, thereby degrading the performance of the secondary battery.

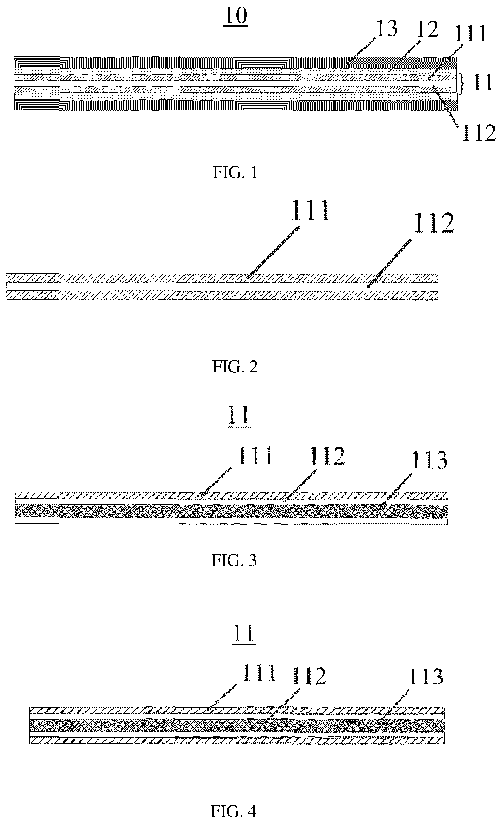

In view of this, a first aspect of the present application provides a secondary battery. The secondary battery includes a positive electrode plate 10. As shown in FIG. 1, the positive electrode plate 10 includes a current collector 11, a first active substance layer 12, and a second active substance layer 13, the first active substance layer 12 includes a first active substance, the second active substance layer 13 includes a second active substance, and the difference between the Dv50 of the second active substance and the Dv50 of the first active substance is a µm, where 2≤a≤10; and the current collector 11 includes an aluminum foil 112 and an aluminized layer 111, the second active substance layer 13, first active substance layer 12, aluminized layer 111, and aluminum foil 112 are laminated, the aluminized layer 111 is disposed on a first surface of the aluminum foil 112, and the aluminized layer 111 is in direct contact with the first active substance layer 12. Specifically, the first active substance layer 12 is disposed on the surface of the current collector 11, and the second active substance layer 13 is disposed on the surface of the first active substance layer 12. The "surface" herein may be the entire area or a part of the positive current collector, with no special limitation in the present application, as long as the purpose of the present application can be realized. In the present application, the aluminized layer is disposed on the surface of the aluminum foil and is better bonded with the first active substance layer by using the characteristics of the aluminized layer, such as a strong gas barrier property, a certain surface roughness, and good compactness. By the structure described above and adjusting the difference between the Dv50 of the second active substance and the Dv50 of the first active substance to be within the range of the present application, the secondary battery has a good safety performance and also a reduced internal resistance growth rate.

In some implementations of the present application, the aluminized layer has the thickness of 0.1 µm to 1 µm. By adjusting the thickness of the aluminized layer to be within the scope of the present application, and by utilizing the characteristics of the aluminized layer, such as a strong gas barrier property, a certain surface roughness, and good compactness, the secondary battery has a good safety performance and also a reduced internal resistance growth rate.

In some implementations of the present application, the Dv50 of the first active substance is 0.05 µm to 8 µm, and the Dv50 of the second active substance is 5 µm to 18 µm. Too large Dv50 of the first active substance and second active substance would cause the reduced energy density of the secondary battery, and protruding points at the electrode plate which are easy to break a separator or are unfavorable for bonding; and too small Dv50 of the first active substance and second active substance would cause aggravated side reactions and degraded rate discharge performances. By adjusting the Dv50 of the first active substance and second active substance to be within the scope of the present application, the secondary battery has a good safety performance and also a reduced internal resistance growth rate.

In some implementations of the present application, the difference between the Dv50 of the second active substance and the Dv50 of the first active substance is a µm, where 2≤a≤6, and the aluminized layer has the thickness of H µm, where 0.1≤H≤0.5. When 2≤a≤6, the first active substance has a small specific surface area, and a more uniform gas distribution, and produces small electrochemical corrosion on the aluminum foil. By adjusting the thickness of the aluminized layer to be in the above-described range, it is facilitated to reduce the internal resistance growth rate of the secondary battery.

In some implementations of the present application, the difference between the Dv50 of the second active substance and the Dv50 of the first active substance is a µm, where 6<a≤10. The aluminized layer has the thickness of H µm, where 0.5<H≤1. The inventor finds: if the Dv50 of the first active substance is small and has a large difference with the Dv50 of the second active substance (e.g., 6<a≤10), the specific surface area of the first active substance is large. Thus, it is likely to accumulate the gas generated at the connection interface between the first active substance layer and current collector surface during the electrochemical reaction when the secondary battery is stored at a high temperature, and electrochemical corrosion is caused at the current collector surface, increasing the contact impedance between the current collector surface and first active substance layer, so as to cause an increase in the internal resistance growth rate of the secondary battery. The present application facilitates the reduction of the internal resistance growth rate of the secondary battery by adjusting the thickness of the aluminized layer to be within the above range.

In some implementations of the present application, the first active material includes at least one of lithium iron phosphate, lithium iron manganese phosphate, or lithium manganate, facilitating to improve the safety performance of the secondary battery; the second active material includes at least one of lithium cobaltate, lithium nickelate, lithium manganate, or a nickel-cobalt-manganese ternary, or lithium-rich manganese-based material, facilitating to reduce the side reaction between the positive electrode active material and the electrolyte, and then improving the cycle performance and energy density of the secondary battery. The lithium-rich manganese-based material of the present application is a Li₂MnO₃-based composite cathode material, Li₂MnO₃·LiMO₂, wherein M is a binary or ternary layered material of Ni, Co, Mn, or Ni, Co, Mn.

In some implementations of the present application, the first active material layer includes lithium iron phosphate, facilitating to improve the safety performance of the secondary battery.

In some implementations of the present application, the first active substance layer further includes a conductive agent, and a binder, and based on the mass of the first active substance layer, the lithium iron phosphate has the mass percentage content of 70% to 85%, the conductive agent has the mass percentage content of 5% to 20%, and the binder has the mass percentage content of 0.5% to 5%. By adjusting the contents of the conductive agent and the binder in the first active substance layer to be within the above range, it is facilitated to further improve the safety performance of the secondary battery. The types of the conductive agent and binder are not particularly limited in the present application, as long as the purpose of the present application can be realized. For example, the type of the conductive agent may include at least one of conductive carbon black, carbon nanotubes, graphene, Ketjen Black, or conductive graphite, and the type of the binder may include at least one of PVDF (polyvinylidene fluoride), PVDC (polyvinylidene dichloride), SBR (styrene butadiene rubber), or PAA (polyacrylic acid).

In some implementations of the present application, the first active substance layer further includes a ceramic material and a dispersant, the ceramic material has the mass percentage of 5% to 10%, and the dispersant has the mass percentage of 0.5% to 5%. The types of the ceramic material and dispersant are not particularly limited in the present application, as long as the purpose of the present application can be realized. For example, the type of ceramic material may include at least one of boehmite, alumina, titanium oxide, magnesium oxide, zirconium oxide, or zinc oxide, and the type of the dispersant may include at least one of carboxymethyl cellulose (CMC), polyvinyl alcohol, or polyethylene glycol.

In some implementations of the present application, the first active substance layer has the thickness of b µm, where 0.5≤b≤ 5, and the aluminized layer has the thickness of H µm, where 0.1≤H≤0.5. By synergistically adjusting the thicknesses of the first active substance layer and the aluminized layer to be within the above range, if the secondary battery is punctured, the first active substance layer can effectively encapsulate the aluminum fragments formed by the fracture of the aluminized layer and current collector, improving the safety performance of the secondary battery by reducing the short circuit risk caused by the aluminum fragments, and improving the cycling performance of the secondary battery by reducing the internal resistance growth rate of the secondary battery.

In some implementations of the present application, the first active substance layer has the thickness of b µm, where 5<b≤10, and the aluminized layer has the thickness of H µm, where 0.5<H≤1. By synergistically adjusting the thicknesses of the first active substance layer and the aluminized layer to be within the above range, if the secondary battery is punctured, the first active substance layer can effectively encapsulate the aluminum fragments formed by the fracture of the aluminized layer and current collector, improving the safety performance of the secondary battery by reducing the short circuit risk caused by the aluminum fragments, and improving the cycling performance and energy density of the secondary battery by reducing the internal resistance growth rate of the secondary battery.

In some implementations of the present application, as shown in FIG. 3 or FIG. 4, the current collector 11 further includes a polymer matrix layer 113 which is laminated with the aluminum foil 112, and the polymer matrix layer 113 is disposed on a second surface of the aluminum foil 112, the second surface being opposite to the first surface. The above structure facilitates to the decrease of the contact impedance at the junction of the first active substance layer and the current collector, improving the problem of a relatively large internal resistance growth rate of a positive electrode plate of the secondary battery, so as to reduce the internal resistance growth rate of the secondary battery while enabling the secondary battery to have a good safety performance.

In some implementations of the present application, the material of the polymer matrix layer is at least one of polyimide (PI), polyethylene terephthalate (PET), polyethylene (PE), polypropylene (PP), polyvinylidene chloride (PVDC), polyvinyl chloride (PVC), polytetrafluoroethylene (PTFE), or polyamide (PA). It is facilitated to improve the cycling performance of the secondary battery by selecting the above material for the polymer matrix layer and forming the aluminized layer on the current collector including the polymer matrix layer.

The method of forming the aluminized layer is not particularly limited in present application, as long as the purpose of the present application can be realized. For example, the aluminized layer may be formed by a vacuum evaporation process or a megnetron sputtering process. When vacuum evaporation is used, the aluminized layer can be adjusted by adjusting the vacuum degree, time, and temperature parameters of the vacuum evaporation machine; the higher the vacuum degree is, the better the film formation quality of the aluminized layer is, and the better the uniformity of the aluminized layer is; the higher the temperature is , the faster the film formation speed of the aluminized layer is; and the longer the time is, the greater the thickness of the aluminized layer is.

The particle size grading method is not particularly limited in the present application, as long as the material that meets the particle size requirements can be obtained in the present application. For example, the first active substance and/or the second active substance with different Dv50 can be obtained by grinding and particle size sieving. Particle size sieving tools are not particularly limited in the present application, for example, conventional laser particle analyzers in the art may be used.

A second aspect of the present application provides an electronic device comprising the secondary battery as described in any one of the preceding implementations. The secondary battery provided by the application has a good safety performance and a relatively low internal resistance growth rate, and thus, the electronic device provided by the application has a good safety performance and a rate performance. The electronic devices are not particularly limited in the present application and may include any device in which an electrochemical reaction occurs. In one implementation of the present application, the electronic device may include, but is not limited to: a lithium-ion secondary battery (Li-ion battery), a lithium polymer secondary battery, or a lithium-ion polymer secondary battery, and the like. The structure of the secondary battery of the present application includes, but is not limited to, pouch lithium ion batteries, prismatic hard-shell batteries, or cylindrical hard-shell batteries, and the like.

The preparation method of the positive electrode plate is not particularly in the present application, and a well-known preparation method in the art may be used, as long as the purpose of the present application can be realized. For example, the preparation method of the positive electrode plate includes, but is not limited to, the following steps: dispersing and mixing the first active substance, conductive agent, and binder in a solvent, N methyl pyrrolidone (NMP), to form a homogeneous slurry of the first active substance layer, coating it on a positive current collector, and performing drying; and then dispersing and mixing the second active substance, conductive agent, and binder in a solvent, N methyl pyrrolidone (NMP), to form a homogeneous slurry of the second active substance layer, coating it on the surface of the first active substance layer, and obtaining the positive electrode plate after drying, cold pressing, striping, cutting, and re-drying.

The preparation method of the negative electrode plate is not particularly limited in the present application, and a well-known preparation method in the art may be selected, as long as the purpose of the present application can be realized. For example, the preparation method of the negative electrode plate includes, but is not limited to, the following steps: dispersing and mixing a negative active substance, a conductive agent, a thickener, and a binder in a solvent, N methyl pyrrolidone (NMP), to form a homogeneous negative electrode slurry, coating it on a negative current collector, and obtaining the negative electrode plate after drying, cold pressing, striping, cutting, and re-drying.

The negative electrode plate of the present application includes a negative current collector and a negative active substance layer disposed on at least one surface of the negative current collector. The above-described "a negative active substance layer disposed on at least one surface of the negative current collector" means that the negative active substance layer may be disposed on one surface of the negative current collector in the thickness direction thereof, or may be disposed on both surfaces of the negative current collector in the thickness direction thereof. The "surface" herein may be the entire area or a part of the negative current collector, without special limitation in the present application, as long as the purpose of the present application can be realized. The negative current collector is not limited in the present application, as long as the purpose of the present application can be realized. For example, the negative current collector may include a copper foil, a copper alloy foil, a nickel foil, a titanium foil, a nickel foam, or a copper foam. The negative active substance layer includes the negative active substance. Its type is not particularly limited in the present application, as long as the purpose of the present application can be realized. For example, the negative active substance may include at least one of natural graphite, artificial graphite, soft carbon, hard carbon, intermediate-phase carbon microspheres, a tin-based material, a silicon-based material, lithium titanate, a transition metal nitride, natural scaled graphite, and the like. Optionally, the negative active material layer further includes at least one of a conductive agent, a thickener, and a binder. The types of the conductive agent, thickener, and binder are not particularly limited in the negative active substance layer in the present application, as long as the purpose of the present application can be realized. For example, the negative binder may include, but is not limited to, at least one of polyvinyl alcohol, carboxymethyl cellulose, hydroxypropyl cellulose, diacetyl cellulose, polyvinyl chloride, carboxylated polyvinyl chloride, polyfluoroethylene, polymers containing oxyethylenen, polyvinylpyrrolidone, polyurethane, polytetrafluoroethylene, polyvinylidene dichloride, polyethylene, polypropylene, polyacrylic acid, styrene butadiene rubber, acrylic (ester)-ized styrene butadiene rubber, epoxy resin, or nylon. The mass ratio of the negative active substance, conductive agent, thickener and binder is not particularly limited in the negative active substance layer in the present application, as long as the purpose of the present application can be realized. For example, the mass ratio of the negative active substance, conductive agent, thickener and binder in the negative active substance layer is (97~98): (0~1.5): (0.5-1.5): (1.0-1.9).

Optionally, the negative electrode plate may further include a conductive layer disposed between the negative current collector and negative active substance layer. The components of the conductive layer are not particularly limited in the present application. The conductive layer may be a conventional one in the art, and may include, but is not limited to, the above-described negative conductive agent and negative binder.

The secondary battery of the present application also includes a separator. The separator is not particularly limited in the present application, which can be selected by a person skilled in the art as needed, as long as the purpose of the present application can be realized. For example, the material of the separator may include, but is not limited to, at least one of polyolefin (PO) mainly including polyethylene (PE) and polypropylene (PP), polyester (e.g., polyethylene terephthalate (PET)), cellulose, polyimide (PI), polyamide, (PA), spandex, or aramid; and the type of the separator may include, but is not limited to, at least one of a woven film, a nonwoven film (nonwoven), a microporous film, a composite film, separator paper, a laminating film, or a spinning film. For example, the separator may include a substrate layer and a surface treatment layer. The substrate layer may be a nonwoven fabric, film, or composite film having a porous structure, and the material of the substrate layer may include at least one of polyethylene, polypropylene, polyethylene terephthalate, or polyimide. Optionally, the following may be used: a polypropylene porous film, a polyethylene porous film, a polypropylene nonwoven fabric, a polyethylene nonwoven fabric, or a polypropylene-polyethylene-polypropylene porous composite film. Optionally, a surface treatment layer is provided on at least one surface of the substrate layer, and may be a polymer layer or an inorganic material layer, or a layer formed by mixing a polymer and an inorganic material. For example, the inorganic layer includes inorganic particles and a binder. The inorganic particles are not particularly limited and may for example be selected from at least one of alumina, silicon oxide, magnesium oxide, titanium oxide, hafnium dioxide, tin oxide, cerium dioxide, nickel oxide, zinc oxide, calcium oxide, zirconium oxide, yttrium oxide, silicon carbide, boehmite, aluminum hydroxide, magnesium hydroxide, calcium hydroxide, or barium sulfate. The binder is not particularly limited and may be selected, for example, from at least one of polyvinylidene dichloride, copolymers of vinylidene fluoride-hexafluoropropylene, polyamide, polyacrylonitrile, polyacrylate, polyacrylic acid, polyacrylate, polyvinylpyrrolidone, polyvinyl ether, polymethylmethacrylate, polytetrafluoroethylene or polyhexafluoropropylene. The polymer layer includes a polymer, the material of the polymer includes at least one of polyamide, polyacrylonitrile, acrylate polymers, polyacrylic acid, polyacrylate salts, polyvinylpyrrolidone, polyvinyl ether, polyvinylidene dichloride, or poly(vinylidene fluoride-hexafluoropropylene).

The secondary battery of the present application also includes an electrolyte, which is not particularly limited in the present application, and may be selected by a person skilled in the art as needed, as long as the purpose of the present application can be realized. For example, the electrolyte may be obtained by mixing at least one of ethylene carbonate (also known as ethylencarbonat, abbreviated as EC), propylene carbonate (PC), diethyl carbonate (DEC), ethyl propionate (EP), propyl propionate (PP), methyl ethyl carbonate (EMC), dimethyl carbonate (DMC), vinylene carbonate (VC), fluoroethylene carbonate (FEC), or the like in a certain mass ratio to obtain a nonaqueous organic solvent, and adding a lithium salt to the solvent for dissolving and mixing them homogeneously. The above-described "mass ratio" is not particularly limited in the present application, as long as the purpose of the present application can be realized. The type of lithium salt is not particularly limited in the present application, as long as the purpose of the present application can be realized. For example, the lithium salt may include at least one of LiPF₆, LiBF₄, LiAsF₆, LiClO₄, LiB(C₆H₅)₄, LiCH₃SO₃, LiCF₃SO₃, LiN(SO₂CF₃)₂, LiC(SO₂CF₃)₃, LiSiF₆, lithium bis(oxalate) borate (LiBOB), or lithium difluoroborate. The concentration of the lithium salt in the electrolyte is not particularly limited in the present application, as long as the purpose of the present application can be realized. For example, the concentration of the lithium salt is 1.0 mol/L to 2.0 mol/L.

The secondary battery of the present application also includes a casing which is not particularly limited in the present application and can be selected by a person skilled in the art as needed, as long as the purpose of the present application can be realized. For example, the casing may be an aluminum plastic film, or an aluminum casing, or a stainless steel casing.

The preparation method of the secondary battery is not particularly limited in the present application, and the well-known preparation method in the art can be selected, as long as the purpose of the present application can be realized. For example, the preparation method of the secondary battery includes, but is not limited to, the following steps: sequentially stacking the positive electrode plate, separator, and negative electrode plate, performing winding, folding, and other operations for them as needed to obtain an electrode assembly with a winding structure as needed, placing the electrode assembly into a packaging bag, injecting the electrolyte into the packaging bag, and sealing the bag to obtain the secondary battery.

### Embodiments

Hereinafter, the detailed description of the present application is described in more details by embodiments and comparative embodiments. Various tests and evaluations are performed according to the following methods.

### Test Method and Equipment:

Thickness tests of the aluminized layer, first active substance layer, and second active substance layer:
At (25±3)°C, a positive electrode plate is removed from a lithium-ion battery, and electrolyte residue on the surface of the plate is wiped off; the positive electrode plate is cut in a plasma condition to obtain a cross section thereof; the cross-section is analyzed by a scanning electron microscope (SEM), and the thicknesses of the aluminized layer, first active substance layer, and second active substance layer are tested, with adjacent test points spaced by 2 mm to 3 mm, and with at least 15 different test points, and the thickness of each layer is recorded as the mean value of all test points for each of the aluminized layer, first active substance layer, and second active substance layer.

### Material particle size test:

A particle size test method refers to GB/T 19077-2016. The first active substance layer and the second active substance layer are peeled off by transparent tapes, and a laser particle sizer is used to measure the Dv50 of the first active substance in the first active substance layer, and the second active substance in the second active substance layer. The particle size measurement is performed by measuring the intensity of the scattered light when a laser beam passes through dispersed particles in the test process. The particles used in the test has the refractive index of 1.8. A sample is tested in triplicate, and the particle size is measured as the average value of the three tests to obtain Dv10, Dv50 and Dv90. The laser particle sizer model is Mastersizer3000, Malvern, UK, with a test range of 0.01 µm to 3500 µm, and a detection limit of 10 nm.

### Internal resistance test for secondary battery:

A universal resistance instrument (HT2572) is used to measure the internal resistance of the secondary batteries at sinusoidal 1KHz.

### Internal resistance growth rate test for secondary battery:

At 25±3°C, the secondary battery is charged at a 0.2 C constant current to 4.45V, and then charged at a 4.45V constant voltage to 0.025C, a tested initial internal resistance of the secondary battery is recorded as IMP₀. The secondary battery is placed into a high temperature furnace at 85±3°C for 6 h (hours) and then is taken out, after the temperature of the lithium-ion battery is reduced to 25±3°C, its internal resistance is tested and recorded as "IMP₆ₕ", and the internal resistance growth rate of the secondary battery placed is recorded as (IMP₆ₕ-IMP₀)/IMP₀ × 100% after placing at 85°C for 6h.

### Nail penetration test for secondary battery:

The lithium-ion battery to be tested is placed at a temperature of 25°C±5°C for 5 min, then is charged to 4.45V at a 0.7C constant current, then is charged to 0.02C at a 4.45V constant voltage, and is left for 5 min, so that the battery voltage before nail penetration is 4.45V and the electric quantity of 100%, and the appearance is examined and photographed prior to the test.

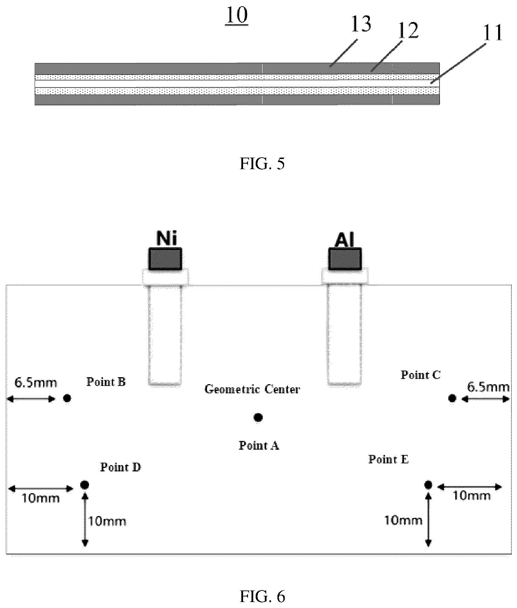

Referring to figure 6, at 20±5°C, the lithium-ion battery to be tested is placed on a test bench, and is penetrated through in one step by a 4mm-diameter steel nail at a speed of 40 mm/s respectively from five positions of the battery: point A (the geometric center of the lithium-ion battery), point B (which is 6.5 mm from the lithium-ion battery's negative electrode edge in the main body in the width direction, and is in the middle of the lithium-ion battery position in the length direction), point C (which is 6.5 mm from the lithium-ion battery's positive electrode edge in the main body in the width direction, and is in the middle of the lithium-ion battery in the length direction), point D (which is at the bottom left corner of the lithium-ion battery, and is 10 mm from the bottom edge and negative electrode edge of the lithium-ion battery), and point E (which is at the bottom right corner of the lithium-ion battery, and is 10 mm from the bottom edge and positive electrode edge of the lithium-ion battery).

With 10 lithium-ion batteries as a group, the state of lithium-ion batteries is observed during testing, and taking no burning and no exploding of the lithium-ion batteries as a judgment standard, the batteries pass the penetrating nail test if more than 6 of 10 penetrating nail tests comply with the standard.

### Embodiment 1

### <Preparation of positive electrode plate>

### <Preparation of current collector>

In a high vacuum (10⁻⁴ mPa) environment, aluminum wires are melted and evaporated into gaseous aluminum at a temperature of 1350°C by resistance heating, then a film winding system is started, a baffle plate is opened, so that the gaseous aluminum particles are deposited on a surface of an aluminum foil, to form a continuous bright aluminized layer with the thickness of 0.5 µm after cooling; after that, the above steps are repeated for the other surface of the aluminum foil substrate, to form a current collector with aluminum plated on both sides. The structure of the current collector is shown in FIG. 2.

### <Preparation of first active substance layer>

Lithium iron phosphate (LFP, with Dv50 of 4 µm, obtained by sieving with a particle size sieving tool), boehmite, carbon nanotubes, PVDF, and CMC are mixed in a mass ratio of 75: 7: 13: 3.5: 1.5, N-methylpyrrolidone (NMP) is added as a solvent, and a first active substance layer slurry is formed with a solid content of 30 wt% by formulation and is stirred well. The first active substance layer slurry is uniformly coated on one surface of the positive current collector by a coating process, and then drying is performed at 90°C to obtain a first active substance layer with the thickness of 5 µm; and then, the above steps are repeated for the other surface of the current collector to form a first active substance layer with both coated sides.

### <Preparation of second active substance layer>

Lithium cobaltate (LCO, with Dv50 of 10 µm, obtained by sieving with a particle size sieving tool), PVDF, and conductive carbon black (SP) are mixed in a mass ratio of 97: 1.5: 1.5, NMP is added as a solvent, and a second active substance layer slurry is formed with a solid content of 75 wt% by formulation, and is stirred well. The second active substance layer slurry is uniformly coated on the surface of the first active substance layer by a coating process, and then drying is performed at 90°C to obtain a second active substance layer with the thickness of 120 µm; and then, the above steps are repeated for the other surface of the first active substance layer to form a second active substance layer with both coated sides. The structure of the positive electrode plate is shown in FIG. 1.

### <Preparation of negative electrode plate>

Artificial graphite, conductive carbon black (SP), styrene-butadiene rubber (SBR), and sodium carboxymethyl cellulose (CMC) are mixed in a mass ratio of 97: 1: 1: 1, and a slurry with a solid content of 75 wt% is formed by formulation by adding deionized water and is stirred well. The slurry is uniformly coated on one surface of the negative current collector copper foil with a thickness of 6 µm, and drying is performed at 85°C to obtain a negative electrode plate with a negative active substance layer with the thickness of 120 µm; then, the above steps are repeated for other surface of the negative electrode plate, to obtain a negative electrode plate with both surfaces coated with the negative active substance; and then the negative electrode plate obtained as described above is subjected to cold pressing, striping, and cutting, and electrode tabs are welded to obtain the negative electrode plate.

### <Preparation of electrolyte>

A non-aqueous organic solvent is obtained by mixing ethylene carbonate, propylene carbonate, diethyl carbonate, propylene propionate, and vinylidene carbonate in a mass ratio of 20: 30: 20: 28: 2. Then lithium salt LiPF6 is formulated with the non-aqueous organic solvent in the mass ratio of 8: 92 to obtain an electrolyte.

### <Preparation of separator>

A porous polyethylene film is used, with the thickness of 7 µm.

### <Preparation of lithium ion battery>

The positive electrode plate, separator, and negative electrode plate prepared above are sequentially laminated in a way that the separator is between the positive electrode plate and negative electrode plate for separation, so as to obtain an electrode assembly by winding. The electrode assembly is placed in an aluminum-plastic film packaging bag and dried, and then the electrolyte is injected, to obtain a lithium-ion battery after vacuum edge sealing, standing, battery formation, degassing, edge cutting, etc.

### Embodiments 2 to 14

Embodiments 2 to 14 are the same as Embodiment 1, except the following: the thickness H of the aluminized layer is adjusted as shown in Table 1 in <Preparation of current collector>, the thickness b of the first active substance layer is adjusted as shown in Table 1 and particle size sieving is performed to adjust the Dv50 of the first active substance as shown in Table 1 in <Preparation of first active substance layer>, and particle size sieving is performed by particle size sieving tools to adjust the Dv50 of the second active substance as shown in Table 1 in <Preparation of second active substance layer>.

### Embodiments 15 to 20

Embodiments 15 to 20 are the same as Embodiment 1 except the following: the type of the first active substance is adjusted as shown in Table 1 in <Preparation of first active substance layer>, and the type of the second active substance is adjusted as shown in Table 1 in <Preparation of second active substance layer>.

### Embodiments 21 to 28

Embodiments 21 to 28 are the same as Embodiment 1, except the following: in <Preparation of current collector>, the material of the current collector substrate layer is adjusted as shown in Table 1 and an aluminum foil is pressed onto both surfaces of the current collector substrate layer by hot pressing.

### Embodiment 29

Embodiment 29 is the same as Embodiment 1, except that the thickness of the aluminized layer is adjusted as shown in Table 1 in <Preparation of current collector>.

### Embodiment 30

Embodiment 30 is the same as Embodiment 1, except that the thickness of the aluminized layer is adjusted as shown in Table 1 in <Preparation of current collector>.

### Comparative Embodiment 2

Comparative Embodiment 2 is the same as Embodiment 1, except that the aluminized layer is not provided in <Preparation of current collector>. The current collector structure is schematically shown in FIG. 5.

**Table 1**

| No. | Difference a between Dv50 of second active substance and Dv50 of first active substance (µm) | Current collector | | First active substance layer | | | Second active substance layer | | Internal resistance growth rate of secondary battery at 85°C, 6 h (%) | Nail penetr ation passing rate of secondary battery |
|---|---|---|---|---|---|---|---|---|---|---|
| | | Thickness H of aluminized layer (µm) | Substrate layer material | Thickness (µm) | Dv50 of first active substance (µm) | Mass percentage of each component | Dv50 of second active substance (µm) | Type of second active substance | | |
| Embodiment 1 | 6 | 0.5 | aluminum foil | 5 | 4 | lithium iron phosphate: boehmite: carbon nanotubes: PVDF: CMC=75: 7: 13: 3.5: 1.5 | 10 | lithium cobaltate | 20.3 | 10/10 |
| Embodiment 2 | 6 | 0.5 | aluminum foil | 0.5 | 5 | lithium iron phosphate: boehmite: carbon nanotubes: PVDF: CMC=75: 7: 13: 3.5: 1.5 | 11 | lithium cobaltate | 19.2 | 10/10 |
| Embodiment 3 | 6 | 0.5 | aluminum foil | 10 | 8 | lithium iron phosphate: boehmite: carbon nanotubes: PVDF: CMC=75: 7: 13: 3.5: 1.5 | 14 | lithium cobaltate | 22.1 | 10/10 |
| Embodiment 4 | 2 | 0.4 | aluminum foil | 5 | 5 | lithium iron phosphate: boehmite: carbon nanotubes: PVDF: CMC=75: 7: 13: 3.5: 1.5 | 7 | lithium cobaltate | 25.8 | 10/10 |
| Embodiment 5 | 4 | 0.4 | aluminum foil | 5 | 1 | lithium iron phosphate: boehmite: carbon nanotubes: PVDF: CMC=75: 7: 13: 3.5: 1.5 | 5 | lithium cobaltate | 27.5 | 10/10 |
| Embodiment 6 | 8 | 0.4 | aluminum foil | 5 | 0.05 | lithium iron phosphate: boehmite: carbon nanotubes: PVDF: CMC=75: 7: 13: 3.5: 1.5 | 8.05 | lithium cobaltate | 41.9 | 10/10 |
| Embodiment 7 | 10 | 0.4 | aluminum foil | 5 | 8 | lithium iron phosphate: boehmite: carbon nanotubes: PVDF: CMC=75: 7: 13: 3.5: 1.5 | 18 | lithium cobaltate | 56.4 | 10/10 |
| Embodiment 8 | 6 | 0.2 | aluminum foil | 3 | 1 | lithium iron phosphate: boehmite: carbon nanotubes: PVDF: CMC=75: 7: 13: 3.5: 1.5 | 7 | lithium cobaltate | 40.6 | 10/10 |
| Embodiment 9 | 6 | 1 | aluminum foil | 5 | 8 | lithium iron phosphate: boehmite: carbon nanotubes: PVDF: CMC=75: 7: 13: 3.5: 1.5 | 14 | lithium cobaltate | 10.8 | 10/10 |
| Embodiment 10 | 5 | 0.1 | aluminum foil | 0.5 | 7 | lithium iron phosphate: boehmite: carbon nanotubes: PVDF: CMC=75: 7: 13: 3.5: 1.5 | 12 | lithium cobaltate | 34.1 | 10/10 |
| Embodiment 11 | 10 | 1 | aluminum foil | 5 | 8 | lithium iron phosphate: boehmite: carbon nanotubes: PVDF: CMC=75: 7: 13: 3.5: 1.5 | 18 | lithium cobaltate | 21.7 | 10/10 |
| Embodiment 12 | 7 | 0.7 | aluminum foil | 7 | 7 | lithium iron phosphate: boehmite: carbon nanotubes: PVDF: CMC=75: 7: 13: 3.5: 1.5 | 14 | lithium cobaltate | 15.3 | 10/10 |
| Embo diment 13 | 6 | 0.5 | alumin um foil | 0.2 | 4 | lithium iron phosphate: boehmite: carbon nanotubes: PVDF: CMC=75: 7: 13: 3.5: 1.5 | 10 | lithium cobaltate | 18.9 | 6/10 |
| Embo diment 14 | 6 | 0.5 | alumin um foil | 15 | 4 | lithium iron phosphate: boehmite: carbon nanotubes: PVDF: CMC=75: 7: 13: 3.5: 1.5 | 10 | lithium cobaltate | 33.5 | 10/10 |
| Embo diment 15 | 6 | 0.5 | alumin um foil | 5 | 4 | lithium iron manganese phosphate: boehmite: carbon nanotubes: PVDF: CMC=75: 7: 13: 3.5: 1.5 | 10 | lithium cobaltate | 20.8 | 10/10 |
| Embo diment 16 | 6 | 0.5 | alumin um foil | 5 | 4 | lithium manganate: boehmite: carbon nanotubes: PVDF: CMC=75: 7: 13: 3.5: 1.5 | 10 | lithium cobaltate | 20.5 | 10/10 |
| Embo diment 17 | 6 | 0.5 | alumin um foil | 5 | 4 | lithium iron phosphate: boehmite: carbon nanotubes: PVDF: CMC=75: 7: 13: 3.5: 1.5 | 10 | lithium nickelate | 21.9 | 10/10 |
| Embo diment 18 | 6 | 0.5 | alumin um foil | 5 | 4 | lithium iron phosphate: boehmite: carbon nanotubes: PVDF: CMC=75: 7: 13: 3.5: 1.5 | 10 | lithium manganate | 21.2 | 10/10 |
| Embo diment 19 | 6 | 0.5 | alumin um foil | 5 | 4 | lithium iron phosphate: boehmite: carbon nanotubes: PVDF: CMC=75: 7: 13: 3.5: 1.5 | 10 | nickel-cobalt-manganese ternary material | 22.4 | 10/10 |
| Embo diment 20 | 6 | 0.5 | alumin um foil | 5 | 4 | lithium iron phosphate: boehmite: carbon nanotubes: PVDF: CMC=75: 7: 13: 3.5: 1.5 | 10 | Li₂MnO₃·Li MnO₂ | 21.6 | 10/10 |
| Embo diment 21 | 6 | 0.5 | PI | 5 | 4 | lithium iron phosphate: boehmite: carbon nanotubes: PVDF: CMC=75: 7: 13: 3.5: 1.5 | 10 | lithium cobaltate | 22.8 | 10/10 |
| Embo diment 22 | 6 | 0.5 | PET | 5 | 4 | lithium iron phosphate: boehmite: carbon nanotubes: PVDF: CMC=75: 7: 13: 3.5: 1.5 | 10 | lithium cobaltate | 23.4 | 10/10 |
| Embo diment 23 | 6 | 0.5 | PE | 5 | 4 | lithium iron phosphate: boehmite: carbon nanotubes: PVDF: CMC=75: 7: 13: 3.5: 1.5 | 10 | lithium cobaltate | 22.5 | 10/10 |
| Embo diment 24 | 6 | 0.5 | PP | 5 | 4 | lithium iron phosphate: boehmite: carbon nanotubes: PVDF: CMC=75: 7: 13: 3.5: 1.5 | 10 | lithium cobaltate | 23.2 | 10/10 |
| Embo diment 25 | 6 | 0.5 | PVDC | 5 | 4 | lithium iron phosphate: boehmite: carbon nanotubes: PVDF: CMC=75: 7: 13: 3.5: 1.5 | 10 | lithium cobaltate | 23.7 | 10/10 |
| Embo diment 26 | 6 | 0.5 | PVC | 5 | 4 | lithium iron phosphate: boehmite: carbon nanotubes: PVDF: CMC=75: 7: 13: 3.5: 1.5 | 10 | lithium cobaltate | 22.9 | 10/10 |
| Embo diment 27 | 6 | 0.5 | PTFE | 5 | 4 | lithium iron phosphate: boehmite: carbon nanotubes: PVDF: CMC=75: 7: 13: 3.5: 1.5 | 10 | lithium cobaltate | 23.1 | 10/10 |
| Embo diment 28 | 6 | 0.5 | PA | 5 | 4 | lithium iron phosphate: boehmite: carbon nanotubes: PVDF: CMC=75: 7: 13: 3.5: 1.5 | 10 | lithium cobaltate | 23.5 | 10/10 |
| Embodiment 29 | 6 | 1.2 | aluminum foil | 5 | 4 | lithium iron phosphate: boehmite: carbon nanotubes: PVDF: CMC=75: 7: 13: 3.5: 1.5 | 10 | lithium cobaltate | 10.6 | 10/10 |
| Embodiment 30 | 6 | 0.05 | aluminum foil | 5 | 4 | lithium iron phosphate: boehmite: carbon nanotubes: PVDF: CMC=75: 7: 13: 3.5: 1.5 | 10 | lithium cobaltate | 52.5 | 10/10 |
| Comparative Embodiment 2 | 6 | / | aluminum foil | 5 | 4 | lithium iron phosphate: boehmite: carbon nanotubes: PVDF: CMC=75: 7: 13: 3.5: 1.5 | 10 | lithium cobaltate | 58.3 | 9/10 |

| | | | | | | | | | | |
|---|---|---|---|---|---|---|---|---|---|---|
| Note: "/" in Table 1 indicates no relevant preparation parameter. | | | | | | | | | | |

Referring to Table 1, as can be seen from Embodiments 1 to 30 and Comparative Embodiment 2, the secondary battery having the positive electrode plate of the present application has a nail penetration passing rate that is substantially not affected, but the internal resistance growth rate is decreased significantly, indicating that the structure of the positive electrode plate of the application can enable the secondary battery having a good safety performance and also a decreased internal resistance growth rate after high-temperature storage.

As can be seen from Embodiments 1 to 5, and 8 to 10, by synergistically adjusting the difference between the Dv50 of the second active substance and the Dv50 of the first active substance, and the thickness of the aluminized layer to be within 2≤a≤ 6 and 0.1≤H≤0.5, it is facilitated to obtain the secondary battery having a good safety performance and a low internal resistance growth rate; and as can be seen from Embodiments 11 to 12, and 6 to 7, by synergistically adjusting the difference between the Dv50 of the second active substance and the Dv50 of the first active substance, and the thickness of the aluminized layer to be within 6≤a≤10, and 0.5≤H≤1, it is facilitated to obtain the secondary battery having a good safety performance and a low internal resistance growth rate.

As can be seen from Embodiments 1, 2, 4, 5, and 8 to 11, by synergistically adjusting the thicknesses of the first active substance layer, and aluminized layer to be within 0.5≤b≤ 5 and 0.1 ≤H≤0.5, it is facilitated to obtain the secondary battery having a good safety performance and a low internal resistance growth rate; and as can be seen from Embodiments 3, 12, 13, and 14, by synergistically adjusting the thicknesses of the first active substance layer, and aluminized layer to be within 5 < b ≤ 10 and where 0.5<H≤1, it is facilitated to obtain the secondary battery having a good safety performance and a low internal resistance growth rate.

As can be seen from Embodiments 9 and 29, the internal resistance growth rate and the nail penetration passing rate of the secondary battery are substantially the same. However, the energy density of the secondary battery may be affected due to the decreased relative content of the active substance in the battery since the thickness of the aluminized layer is relatively large in Embodiment 29. By adjusting the thickness of the aluminized layer to be within the scope of the present application, it is facilitated to obtain the secondary battery having a good comprehensive performance by the balance of the safety performance, internal resistance growth rate and energy density thereof.

The types of the first and second active substances usually also influence the performance of the secondary battery. As can be seen from Embodiments 1, and 15-20, by adjusting the types of the first and second active substances to be within the scope of the present application, it is facilitated to obtain the secondary battery having a good safety performance and a low internal resistance growth rate.

The type of the current collector matrix substrate layer usually also influences the performance of the secondary battery. As can be seen from Embodiments 1, and 21-28, by adjusting the material of the current collector matrix substrate layer to be within the scope of the present application, it is facilitated to obtain the secondary battery having a good safety performance and a low internal resistance growth rate.

Specifically, relation terms herein, such as, first and second, are used only to distinguish one item or operation from another, and do not necessarily require or imply any such actual relation or order between these items or operations. Furthermore, terms "include", "including", or any other variant thereof, are intended to encompass non-exclusive inclusion, such that a process, a method, an article, or an apparatus including a serial of elements includes not only those elements, but also other elements not expressly listed, or also includes elements that are inherent to such process, method, article, or apparatus. Unless otherwise indicated, the presence of another identical element is not excluded by the element defined by the phrasing "including ......" in the process, method, article, or apparatus including the element.

Only preferred embodiments of the present application are described above and are not intended to limit the scope of protection of the application as defined in the appended claims.

## Claims

1. A secondary battery, comprising a positive electrode plate (10);
the positive electrode plate (10) comprises a current collector (11), a first active substance layer (12), and a second active substance layer (13); the first active substance layer (12) comprises a first active substance, the second active substance layer comprises a second active substance, and a difference between a Dv50 of the second active substance and a Dv50 of the first active substance is a µm, where 2≤a≤10; wherein Dv50 is obtained by the method as described in the description; and
the current collector (11) comprises an aluminum foil (112), and an aluminized layer (111); **characterized in that**
the second active substance layer (13), the first active substance layer (12), the aluminized layer, and the aluminum foil (112) are laminated; the aluminized layer (111) is disposed on a first surface of the aluminum foil (112), and the aluminized layer (111) is in direct contact with the first active substance layer (12).

2. The secondary battery according to claim 1, **characterized in that** the aluminized layer (111) has a thickness as obtained by the method as described in the description of 0.1 µm to 1 µm.

3. The secondary battery according to claim 1 or 2, **characterized in that** the Dv50 of the first active substance is 0.05 µm to 8 µm, and the Dv50 of the second active substance is 5 µm to 18 µm.

4. The secondary battery according to any one of claims 1-3, **characterized in that** 2≤a≤6, and the aluminized layer (111) has a thickness of H µm, where 0.1≤H≤0.5.

5. The secondary battery according to any one of claims 1-3, **characterized in that** 6<a≤10, and the aluminized layer (111) has a thickness of H µm, where 0.5<H≤1.

6. The secondary battery according to any one of claims 1-4, **characterized in that** the first active substance comprises at least one of lithium iron phosphate, lithium iron manganese phosphate, or lithium manganate; and the second active substance comprises at least one of lithium cobaltate, lithium nickelate, lithium manganate, a nickel-cobalt-manganese ternary, or a lithium-rich manganese-based material.

7. The secondary battery according to claim 6, **characterized in that** the first active substance comprises lithium iron phosphate.

8. The secondary battery according to claim 7, **characterized in that** the first active substance layer (12) further comprises a conductive agent, and a binder; and based on a mass of the first active substance layer (12), the lithium iron phosphate has a mass percentage content of 70% to 85%, the conductive agent has a mass percentage content of 5% to 20%, and the binder has a mass percentage content of 0.5% to 5%.

9. The secondary battery according to claim 7, **characterized in that** the first active substance layer (12) has a thickness of b µm, where 0.5≤b≤5, and the aluminized layer (111) has a thickness of H µm, where 0.1≤H≤0.5.

10. The secondary battery according to claim 7, **characterized in that** the first active substance layer (12) has a thickness of b µm, where 5<b≤10, and the aluminized layer (111) has a thickness of H µm, where 0.5<H≤ 1.

11. The secondary battery according to any one of claims 1-10, **characterized in that** the current collector (11) further comprises a polymer matrix layer (113), the polymer matrix layer (113) is laminated with the aluminum foil (112), the polymer matrix layer (113) being disposed on a second surface of the aluminum foil (112), the second surface being opposite to the first surface.

12. The secondary battery according to claim 11, **characterized in that** the material of the polymer matrix layer (113) is at least one of polyimide, polyethylene terephthalate, polyethylene, polypropylene, polyvinylidene chloride, polyvinyl chloride, polytetrafluoroethylene, or polyamide.

13. An electronic device, comprising the secondary battery according to any one of claims 1-12.

## Patentansprüche

1. Sekundärbatterie, umfassend eine positive Elektrodenplatte (10);
wobei die positive Elektrodenplatte (10) einen Stromabnehmer (11), eine erste Wirkstoffschicht (12) und eine zweite Wirkstoffschicht (13) umfasst; die erste Wirkstoffschicht (12) einen ersten Wirkstoff umfasst, die zweite Wirkstoffschicht einen zweiten Wirkstoff umfasst, und eine Differenz zwischen einem Dv50 des zweiten Wirkstoffs und einem Dv50 des ersten Wirkstoffs ein µm ist, wobei 2≤a≤10;
wobei Dv50 durch das in der Beschreibung beschriebene Verfahren erhalten wird; und der Stromabnehmer (11) eine Aluminiumfolie (112) und eine aluminisierte Schicht (111) umfasst; **dadurch gekennzeichnet, dass**
die zweite Wirkstoffschicht (13), die erste Wirkstoffschicht (12), die aluminisierte Schicht und die Aluminiumfolie (112) laminiert sind; die aluminisierte Schicht (111) auf einer ersten Oberfläche der Aluminiumfolie (112) angeordnet ist, und die aluminisierte Schicht (111) in direktem Kontakt mit der ersten Wirkstoffschicht (12) steht.

2. Sekundärbatterie nach Anspruch 1, **dadurch gekennzeichnet, dass** die aluminisierte Schicht (111) eine Dicke, wie durch das in der Beschreibung beschriebene Verfahren erhalten, von 0,1 µm bis 1 µm aufweist.

3. Sekundärbatterie nach Anspruch 1 oder 2, **dadurch gekennzeichnet, dass** der Dv50 des ersten Wirkstoffs 0,05 µm bis 8 µm ist, und der Dv50 des zweiten Wirkstoffs 5 µm bis 18 µm ist.

4. Sekundärbatterie nach einem der Ansprüche 1-3, **dadurch gekennzeichnet, dass** 2≤a≤6 und die aluminisierte Schicht (111) eine Dicke von H µm aufweist, wobei 0,1≤H≤0,5.

5. Sekundärbatterie nach einem der Ansprüche 1-3, **dadurch gekennzeichnet, dass** 6<a≤10 und die aluminisierte Schicht (111) eine Dicke von H µm aufweist, wobei 0,5<H≤1.

6. Sekundärbatterie nach einem der Ansprüche 1-4, **dadurch gekennzeichnet, dass** der erste Wirkstoff mindestens eines von Lithiumeisenphosphat, Lithiumeisenmanganphosphat oder Lithiummanganat umfasst; und der zweite Wirkstoff mindestens eines von Lithiumkobaltat, Lithiumnickelat, Lithiummanganat, einem Nickel-Kobalt-Mangan-Ternär oder einem lithiumreichen Material auf Manganbasis umfasst.

7. Sekundärbatterie nach Anspruch 6, **dadurch gekennzeichnet, dass** der erste Wirkstoff Lithium-Eisen-Phosphat umfasst.

8. Sekundärbatterie nach Anspruch 7, **dadurch gekennzeichnet, dass** die erste Wirkstoffschicht (12) weiter ein leitfähiges Mittel und ein Bindemittel umfasst; und das Lithiumeisenphosphat basierend auf einer Masse der ersten Wirkstoffschicht (12) einen Massenprozentgehalt von 70% bis 85% aufweist, das leitfähige Mittel einen Massenprozentgehalt von 5% bis 20% aufweist und das Bindemittel einen Massenprozentgehalt von 0,5% bis 5% aufweist.

9. Sekundärbatterie nach Anspruch 7, **dadurch gekennzeichnet, dass** die erste Wirkstoffschicht (12) eine Dicke von b µm aufweist, wobei 0,5≤b≤5, und die aluminisierte Schicht (111) eine Dicke von H µm aufweist, wobei 0,1≤H≤0,5.

10. Sekundärbatterie nach Anspruch 7, **dadurch gekennzeichnet, dass** die erste Wirkstoffschicht (12) eine Dicke von b µm aufweist, wobei 5<b≤10, und die aluminisierte Schicht (111) eine Dicke von H µm aufweist, wobei 0,5<H≤ 1.

11. Sekundärbatterie nach einem der Ansprüche 1-10, **dadurch gekennzeichnet, dass** der Stromabnehmer (11) weiter eine Polymermatrixschicht (113) umfasst, die Polymermatrixschicht (113) mit der Aluminiumfolie (112) laminiert ist, wobei die Polymermatrixschicht (113) auf einer zweiten Oberfläche der Aluminiumfolie (112) angeordnet ist, wobei die zweite Oberfläche der ersten Oberfläche gegenüberliegt.

12. Sekundärbatterie nach Anspruch 11, **dadurch gekennzeichnet, dass** das Material der Polymermatrixschicht (113) mindestens eines aus Polyimid, Polyethylenterephthalat, Polyethylen, Polypropylen, Polyvinylidenchlorid, Polyvinylchlorid, Polytetrafluorethylen, oder Polyamid ist.

13. Elektronische Vorrichtung, welche die Sekundärbatterie nach einem der Ansprüche 1-12 umfasst.

## Revendications

1. Une batterie secondaire, comprenant une plaque d'électrode positive (10) ;
la plaque d'électrode positive (10) comprend un collecteur de courant (11), une première couche de substance active (12) et une seconde couche de substance active (13) ; la première couche de substance active (12) comprend une première substance active, la seconde couche de substance active comprend une seconde substance active, et la différence entre le Dv50 de la seconde substance active et le Dv50 de la première substance active est de a µm, où 2≤a≤10 ; le Dv50 étant obtenu selon la méthode décrite dans la description, et le collecteur de courant (11) comprend une feuille d'aluminium (112) et une couche aluminisée (111) ; **caractérisé en ce que**
la seconde couche de substance active (13), la première couche de substance active (12), la couche aluminisée et la feuille d'aluminium (112) sont laminées ; la couche aluminisée (111) est disposée sur une première surface de la feuille d'aluminium (112) et la couche aluminisée (111) est en contact direct avec la première couche de substance active (12).

2. La batterie secondaire selon la revendication 1, **caractérisée en ce que** la couche aluminisée (111) a une épaisseur telle qu'obtenue par la méthode décrite dans la description de 0,1 µm à 1 µm.

3. La batterie secondaire selon la revendication 1 ou 2, **caractérisée en ce que** le Dv50 de la première substance active est de 0,05 µm à 8 µm et le Dv50 de la deuxième substance active est de 5 µm à 18 µm.

4. La batterie secondaire selon l'une quelconque des revendications 1-3, **caractérisée en ce que** 2≤a≤6, et la couche aluminisée (111) a une épaisseur de H µm, où 0,1≤H≤0,5.

5. La batterie secondaire selon l'une quelconque des revendications 1-3, **caractérisée en ce que** 6<a≤10, et la couche aluminisée (111) a une épaisseur de H µm, où 0,5<H≤1.

6. La batterie secondaire selon l'une quelconque des revendications 1-4, **caractérisée en ce que** la première substance active comprend au moins l'un des composés suivants : phosphate de fer lithié, phosphate de manganèse de fer lithié, ou manganate de lithium; et la seconde substance active comprend au moins l'un des composés suivants : cobaltate de lithium, nickelate de lithium, manganate de lithium, un composé ternaire nickel-cobalt-manganèse ou un matériau à base de manganèse riche en lithium.

7. La batterie secondaire selon la revendication 6, **caractérisée en ce que** la première substance active comprend du phosphate de fer lithié.

8. La batterie secondaire selon la revendication 7, **caractérisée en ce que** la première couche de substance active (12) comprend en outre un agent conducteur, et un liant ; et sur la base d'une masse de la première couche de substance active (12), le phosphate de fer lithié a une teneur en pourcentage massique de 70 % à 85 %, l'agent conducteur a une teneur en pourcentage massique de 5 % à 20 % et le liant a une teneur en pourcentage massique de 0,5 % à 5 %.

9. La batterie secondaire selon la revendication 7, **caractérisée en ce que** la première couche de substance active (12) a une épaisseur de b µm, où 0,5≤b≤5, et la couche aluminisée (111) a une épaisseur de H µm, où 0,1≤H≤0,5.

10. La batterie secondaire selon la revendication 7, **caractérisée en ce que** la première couche de substance active (12) a une épaisseur b µm, où 5<b≤10, et la couche aluminisée (111) a une épaisseur H µm, où 0.5<H≤ 1.

11. La batterie secondaire selon l'une quelconque des revendications 1 à 10, **caractérisée en ce que** le collecteur de courant (11) comprend en outre une couche de matrice polymère (113), la couche de matrice polymère (113) est laminée avec la feuille d'aluminium (112), la couche de matrice polymère (113) étant disposée sur une seconde surface de la feuille d'aluminium (112), la seconde surface étant opposée à la première surface.

12. La batterie secondaire selon la revendication 11, **caractérisée en ce que** le matériau de la couche de matrice polymère (113) est au moins un de polyimide, téréphtalate de polyéthylène, polyéthylène, polypropylène, chlorure de polyvinylidène, chlorure de polyvinyle, polytétrafluoroéthylène ou polyamide.

13. Dispositif électronique, comprenant la batterie secondaire selon l'une quelconque des revendications 1 à 12.
